# EUROPEAN PATENT SPECIFICATION

(11) **EP 4 571 189 B1**
(45) Date of publication and mention of the grant of the patent: **29.07.2026**
(21) Application number: 24214564.7
(22) Date of filing: 21.11.2024
(51) Int. Cl.: F23N 5/08

(54) **MONITORING DEVICE, BURNING APPLIANCE AND SELF-TESTING METHOD**
ÜBERWACHUNGSVORRICHTUNG, VERBRENNUNGSGERÄT UND SELBSTTESTVERFAHREN
DISPOSITIF DE SURVEILLANCE, APPAREIL DE COMBUSTION ET PROCÉDÉ D'AUTO-TEST

(30) Priority: 15.12.2023 GB 202319232
(43) Date of publication of application: 18.06.2025
(73) Proprietor: Bosch Thermotechnology Ltd (UK), Worcester, Worcestershire WR4 9SW (GB)
(72) Inventor: Batema, Hugo, 7418 BG Deventer (NL); Snijder, Ab, 8051 JH Hattem (NL)
(74) Representative: Bee, Joachim

(56) References cited:
- CN-Y- 2 644 910
- GB-A- 2 595 499
- US-A- 4 322 723
- US-A- 5 264 708
- US-A- 6 060 719

## Description

### Prior art

A monitoring device, in particular flame monitoring device, with at least one monitoring electronics unit comprising at least one optical sensor, in particular an UV-sensor, for monitoring a flame, and comprising an amplifier electronics unit, in particular with at least one transimpedance amplifier, at least for an amplification of a sensor signal output by the optical sensor is already known. GB 2595499 A discloses a flame sensor for a hydrogen flame with an optical sensor and a failure protection device

### Disclosure of the invention

The invention is based on a monitoring device, in particular flame monitoring device, with at least one monitoring electronics unit comprising at least one optical sensor, in particular a UV-sensor, for monitoring a flame, and comprising an amplifier electronics unit, in particular with at least one transimpedance amplifier, at least for an amplification of a sensor signal output by the optical sensor.

It is proposed that the monitoring electronics unit comprises a test electronics unit configured for autonomously testing at least the optical sensor and the amplifier electronics unit of the monitoring electronics unit separately from each other during operation.

The monitoring device according to the invention can advantageously provide a precise monitoring, because in particular the optical sensor and the amplifier electronics are tested separately from each other and thereby it can be determined whether the optical sensor or the amplifier electronics are defective/intact or whether the circuit is just stuck. Advantageously, a high level of operational reliability can be provided, because in particular a detailed information about a functionality of the monitoring device can be determined precisely. Advantageously, a high level of comfort/operational safety can be provided, because in particular an interruption of the measurement for checking the optical sensor and the amplifier electronics is very short.

Preferably, the monitoring device is configured to detect a flame, in particular a hydrogen flame, of an automatically operated burning appliance and/or an automatic burner control system. In particular, the monitoring device is configured to detect an electromagnetic radiation, preferably in a UV-range and/or in a visible range and/or in an infrared range. Preferably, the burning appliance is configured to burn gaseous and/or liquid fuels. It is also conceivable that the monitoring device is used to detect a glowing wire and/or an ambient brightness and/or a comparable electromagnetic radiation. It is conceivable that the monitoring device is part of the control system of the burning appliance or is used to regulate the flame/burning appliance. Preferably, the monitoring device is configured to convert a light intensity, in particular a wavelength range of the electromagnetic radiation emitted by the flame, into a proportional electrical voltage output signal. Preferably, the monitoring device comprises at least one monitoring electronics unit. Preferably, the monitoring device comprises at least one housing, which is configured to protect and hold/fix the monitoring electronics unit. It is conceivable that the monitoring device comprises optical elements, for example optical waveguides and/or optical lenses and/or optical apertures or the similar. Preferably, the monitoring device has a control unit, which is configured to initiate the functional test. Preferably, the control unit is configured to control the test electronics. Preferably, the control unit is configured to supply the test electronics and/or the monitoring device with electrical energy/voltage.

Preferably the monitoring electronics unit comprises an optical sensor which is configured as at least one photodiode. Preferably, the photodiode comprises at least one UV-sensitive measuring range. Alternatively, the optical sensor could also be an infrared sensor or a sensor with a wavelength range that appears reasonable to the person skilled in the art. Preferably, the optical sensor is configured to convert a light intensity at least of one range, preferably UV-range, of the electromagnetic radiation emitted by the flame into an electric current.

Preferably, the monitoring electronics unit has at least one amplifier electronics unit which is configured to convert the electrical current generated by the optical sensor into a voltage signal. In particular, the amplifier electronics unit is configured to amplify the voltage signal. Preferably, the amplifier electronics unit has at least one operational amplifier, which is configured to convert the electric current into an electric voltage. Preferably, the operational amplifier is circuited as a transimpedance amplifier. Preferably, the amplifier electronics unit comprises at least one resistor which is configured to amplify the voltage of the operational amplifier. It is imaginable that the amplifier electronics unit comprises at least one capacitor which is configured to suppress/eliminate noise.

Preferably, the test electronics unit is configured to test the optical sensor and to test the amplifier electronics unit separately/ independently of each other, preferably separated in time. In particular, the monitoring device comprises at least one control and/or regulating unit which is configured to activate the test electronic unit automatically, preferably at periodic intervals, for a test of the optical sensor and a test of the amplifier electronics unit and/or to initiate a test sequence of the test electronics unit. In this context, the term "automatic" is to be interpreted as meaning in particular self-activating, for example free of any influence by an operator. In this context, the term "separate" is to be interpreted in particular as an independent test result of each different component, so that an independent test result of different components is determined. In particular, the test result is configured to provide an information as to which of the tested components is defective. Preferably, the test electronic unit is configured to differentiate a defective component from a stuck signal.

It is moreover proposed that the monitoring electronics unit is realized free of movable mechanical components, like for example a covering screen. Advantageously, a high level of comfort can be provided, because in particular an interruption of the measurement for testing the optical sensor and the amplifier electronics is very short without a moving mechanical component. Advantageously, a high level of reliability can be provided, because in particular maintenance-intensive moving mechanical components can be avoided. Advantageously, a low complexity/costs can be provided, because moving mechanical components in particular can be eliminated. Preferably, a sight glass is arranged between the light source, in particular the UV-LED, and the optical sensor. Preferably, the function test is performed during regular operation, especially without covering the optical element. It is imaginable that the light source is optically connected to the optical sensor via an optical element, such as a mirror, a prism or a light wave guide. In this context the term "movable" is to be interpreted in particular as a mechanical component which is configured to be moved to provide a function.

Furthermore, it is proposed, that the test electronics unit comprises at least one voltage source, which is configured to subject the amplifier electronics unit regularly, in particular at least every hour, to a voltage impulse for a functionality test. Advantageously, a low-cost design can be provided, because in particular the test can easily be executed by applying a voltage, and therefore a complex mechanical system for covering the optical sensor can be avoided. Advantageously, a high degree of reliability/safety can be provided, because moving mechanical components in particular can be avoided. Advantageously, a low response time can be provided, because the voltage impulse in particular can be applied very fast. Preferably, the voltage impulse is configured to be applied automatically and/or autonomously. Preferably, the voltage source is configured as a power supply. Preferably, the voltage source is configured as a logical signal, in particular TTL-signal (transistor-transistor-logic), especially powered by the power supply. It is imaginable, that the voltage source is embodied as a battery. It is imaginable that the voltage source comprises further components, such as rectifiers and/or voltage converters and/or the equivalent. It is imaginable that an interval for executing the function test is adjustable/changeable. In this context the term "regular" is to be interpreted in particular in repetitive.

It is moreover proposed that the test electronics unit is configured to deactivate, in the functionality test of the amplifier electronics unit, the optical sensor, in particular to set the optical sensor back, out of a measuring-sensitive range, by the voltage impulse. Advantageously, a very precise test result can be provided, because in particular the optical sensor no longer affects the test result of the amplifier electronics. Advantageously, a high level of operational reliability can be provided, because in particular a detailed information about a functionability of the monitoring device can be determined. Preferably, the voltage impulse prevents the optical element from generating an electric current. The term "measuring-sensitive range" is to be understood in particular as a state in which the optical element outputs a measuring signal.

Furthermore, it is proposed, that the test electronics unit comprises at least one light source, in particular a UV-LED, which is configured to subject the optical sensor to a light impulse for a functionality test. Advantageously, low costs can be provided because the UV-LED in particular is designed as a standard component. Advantageously, a low response time can be provided, because in particular a light impulse from the UV-LED can be applied to the optical sensor at least substantially in real time. Advantageously, a high reliability can be provided, because in particular the light impulse can be applied very precisely with the UV-LED. Preferably, the light source is at least a UV-LED. Alternatively, the light source could also be at least an IR-LED and/or a polychromatic light source. The term "LED" (light-emitting diode) is to be understood in particular as a semiconductor component, preferably a diode, which emits light when electric current flows in a forward direction. A "light impulse" is to be understood in particular as electromagnetic radiation and/or electromagnetic radiation energy, preferably with a wavelength in a UV range and/or in the visible light range and/or in the IR range, which has a defined duration of action/ duration of time. In this context, "at least substantially" is to be understood in particular as meaning that a deviation from a specified value is in particular less than 25%, preferably less than 10% and particularly preferably less than 5% of the specified value.

It is moreover proposed that the test electronics unit is configured to subject the optical sensor to the light impulse temporally after the voltage impulse. Advantageously, a precise test result can be provided, because in particular the function of the optical sensor and the amplifier electronics unit can be determined separately by the sequential testing. Preferably, the voltage impulse changes into the light impulse at least substantially continuously in terms of time. Preferably, the light impulse has a start time which at least substantially overlaps with an end time of the voltage impulse. It is imaginable that the voltage impulse and the light impulse are arranged to partially overlap in time. Preferably, a start of the light pulse and an end of the voltage pulse are separated in time by less than 5 ms.

Furthermore, it is proposed, that the test electronics unit is configured to subject the optical sensor to the light impulse with a temporal delay relative to the voltage impulse. Advantageously, a very precise test result can be provided because, in particular, a response time for the amplifier electronics is provided before a light impulse is applied to the optical sensor. Preferably, the time delay is at least 5 ms, preferably at least 10 ms and particularly preferably at least 30 ms. In particular, the time delay is at least substantially determined by the reaction time of the amplifier electronics, preferably by the reaction time of the optical element and by the reaction time of the capacitor and further elements of the amplifier electronics. Preferably, the time delay is configured as a response time of the functional test. It is imaginable that the functional test of the optical sensor is not executed, if the electrical functional test of the amplifier circuit fails, for example if a maximum response time is exceeded. The maximum response time could exemplarily be 10 ms or 20 ms or a comparable time limit that seems reasonable to the person skilled in the art.

It is moreover proposed that the light impulse is configured to put the optical sensor back into the measuring-sensitive range. Advantageously, a good test function can be provided, because in particular the light source put the optical sensor back into the measuring-sensitive range and thus the functional test can be carried out more quickly. Advantageously, a low response time can be provided, because in particular a light impulse from the UV-LED can be applied to the optical sensor at least substantially in real time. Advantageously, a high reliability can be provided, because in particular the light impulse can be applied very precisely with the UV-LED. Preferably, the light impulse is configured to produce a defined response time to perform the functional test more precisely. Preferably, the delay of the optical sensor depends on the light intensity of the UV-LED and/or the flame. Preferably, the UV-LED ensures that the functional test of the optical element is at least substantially independent of the light intensity of the flame.

Additionally, a burning appliance with at least one monitoring device is proposed. Advantageously, a precise monitoring can be provided, because in particular the optical sensor and the amplifier electronics are tested separately from each other and thereby it can be determined whether the optical sensor or the amplifier electronics are defective or whether the circuit is just stuck. Advantageously, a high level of operational reliability can be provided, because in particular a detailed information about a functionality of the monitoring device can be determined. Advantageously, a high level of comfort can be provided, because in particular an interruption of the measurement for checking the optical sensor and the amplifier electronics is very short.

Furthermore, a self-testing method of a monitoring device is proposed wherein in a first test step a voltage impulse is applied and an output voltage generated by the voltage impulse, in particular a voltage impulse response of an amplifier electronics unit, is registered at an output of the amplifier electronics unit in terms of measuring technology. Advantageously, a precise monitoring can be provided, because in particular the optical sensor and the amplifier electronics are tested separately from each other and thereby it can be determined whether the optical sensor or the amplifier electronics are defective or whether the circuit is just stuck. Preferably, the output voltage is measured as a voltage at the output of the amplifier electronics against neutral, for example a ground. Preferably, the voltage impulse at the amplifier electronics generates an output voltage, preferably amplified, which is measured as a voltage impulse response. Preferably, the optical element is deactivated by the voltage impulse.

Additionally, it is proposed, that in a second test step a light impulse is applied and an output voltage generated by the light impulse, in particular a light impulse response of the amplifier electronics unit, is registered at the output of the amplifier electronics unit in terms of measuring technology. Advantageously, a low response time can be provided, because in particular a light impulse from the UV-LED can be applied to the optical sensor at least substantially in real time. Advantageously, a high reliability can be provided, because in particular the light impulse can be applied very precisely with the UV-LED. Preferably, the light impulse at the amplifier electronics generates an output voltage, preferably amplified, which is measured as a light impulse response. Preferably, the optical element is reactivated by the light impulse.

Furthermore it is proposed, that in the first test step an output voltage is generated by the voltage impulse, which is different from the output voltages that are to be expected in a regular operation of the monitoring device. Advantageously, a high reliability can be provided, because in particular the test voltage, that is different from a regular control voltage, enables an explicit and/or precise evaluation. Preferably, the output voltage generated by the voltage impulse is greater, preferably at least twice as great, than the voltage that is to be expected in a control mode of the monitoring device. Preferably, the control and/or regulating unit recognizes whether a self-test is being executed or whether a control operation is being executed. For example, it is also possible to measure an output voltage during regular operation, which is expected for the function test.

Supplementary it is proposed, that in the second test step an output voltage is generated by the light impulse, which is different from the output voltages that are to be expected in a regular operation of the monitoring device. Advantageously, a high reliability can be provided, because in particular the test voltage, that is different from a regular control voltage, enables an explicit and/or precise evaluation. Preferably, the output voltage generated by the voltage impulse is greater than the voltage that is to be expected in a control mode of the monitoring device.

Furthermore, it is proposed, that the first test step for the functionality test of the amplifier electronics unit and the second test step for the functionality test of the optical sensor are carried out in a time interval of less than 1 s, preferably in less than 0.1 s. Advantageously, a high level of comfort/operational safety can be provided, because in particular an interruption of the measurement for checking the optical sensor and the amplifier electronics is very short.

The monitoring device according to the invention, the burning appliance according to the invention and the self-testing method according to the invention are not intended to be limited to the application and embodiment described above. In particular, the monitoring device according to the invention, the burning appliance according to the invention and the self-testing method according to the invention may have a number of individual elements, components and units as well as process steps deviating from a number mentioned herein in order to fulfill a mode of operation described herein. In addition, for the ranges of values specified in this disclosure, values lying within the specified limits are also to be considered disclosed and usable as desired.

### Drawings

Further advantages may be gathered from the following description of the drawings. In the drawings an exemplary embodiment of the invention is shown. The drawings, the description and the claims comprise a plurality of features in combination. The person skilled in the art will expediently also consider the features individually and will bring them together in further purposeful combinations.

The drawings show:
- Fig. 1: a burning appliance with a monitoring device,
- Fig. 2: a schematic diagram of the monitoring device with a monitoring electronics unit and a test electronics unit,
- Fig. 3: a schematic diagram of an output signal of a functional test of the optical sensor and the amplifier electronics and
- Fig. 4: a schematic flowchart of a self-test method.

### Description of the exemplary embodiment

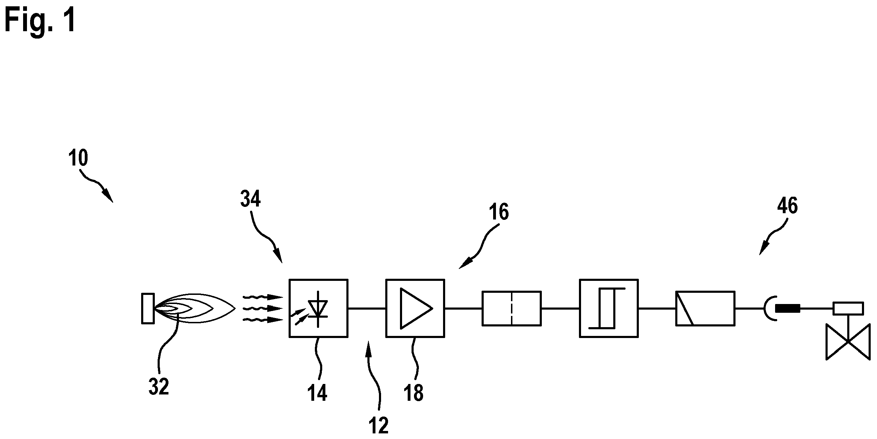

The figure 1 shows a burning appliance 10. The burning appliance 10 comprises a flame 32. The flame 32 is embodied as a hydrogen flame 32. The flame 32 could also be configured as a natural gas flame or oil flame or a comparable flame 32. The burning appliance 10 comprises one monitoring device 34. The monitoring device 34 is embodied as a flame 32 monitoring device 34. The burning appliance 10 could comprise more than one monitoring device 34, for example to detect different spectral ranges of the flame 32. The monitoring device 34 meets the design and construction requirements according to EN298. The monitoring device 34 could also be configured to control/regulate the burning appliance 10. The monitoring device 34 comprises one monitoring electronics unit 12. The monitoring electronics unit 12 comprises one optical sensor 14. The optical sensor 14 is embodied as a UV-photodiode and/or a UV-sensor. Alternatively or additionally, the optical sensor 14 could also comprise a detection range in an IR range and/or in a visible light range. The optical sensor 14 is configured to monitor the flame 32. The flame 32 comprises a light intensity. The light intensity is configured as the intensity of an electromagnetic wavelength of the flame 32. The optical sensor 14 converts the light intensity/electromagnetic wavelength into an electric current. The electric current intensity is proportional to the light intensity. The monitoring electronics unit 12 comprises an amplifier electronics unit 16. The amplifier electronics unit 16 is configured to amplify a sensor signal output by the optical sensor 14. The amplifier electronics unit 16 is configured to amplify the electric current of the optical sensor 14. In a regular mode, which is configured to monitor the flame 32, the amplifier electronics unit 16 is designed/connected as a transimpedance amplifier 18. The monitoring electronics unit 12 is realized free of movable mechanical components, like for example a covering screen which covers/recovers the optical sensor 14. The burning appliance 10 could further comprise components, such as optical waveguides and/or optical elements, such as mirrors, prisms, lenses or the like, and/or housings. It is imaginable that the burning appliance 10 comprises at least one shutter, which is intended for use in an oil burning appliance 10. The monitoring device 34 has a control and/or regulating unit 46. The control and/or regulating unit 46 is configured to initiate/control the flame monitoring and initiate a regular check of the monitoring device.

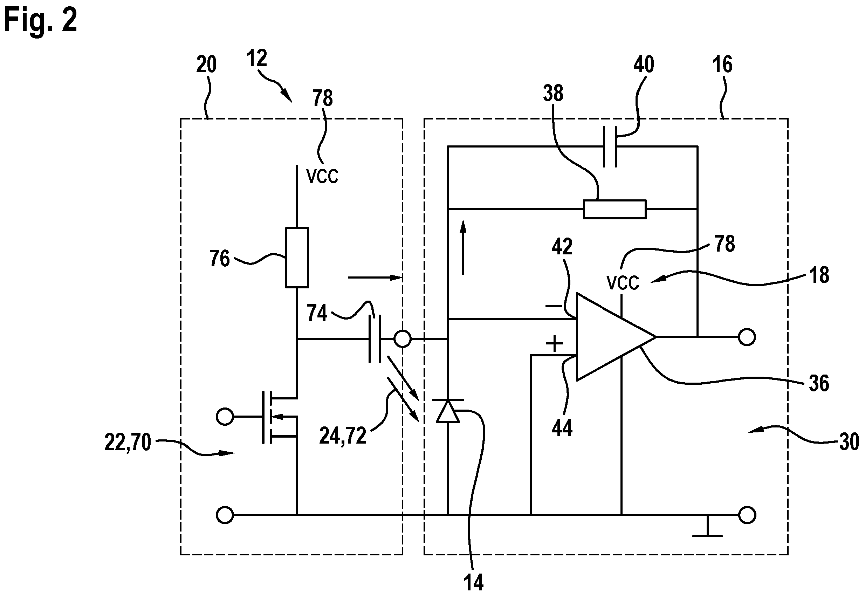

The figure 2 shows a schematic electronic circuit diagram of the monitoring electronics unit 12. The monitoring electronics unit 12 comprises a test electronics unit 20. The test electronics unit 20 is configured to test the amplifier electronics unit 16 and the optical sensor 14 at regular intervals. The test electronics unit 20 is configured to test the optical sensor 14 and the amplifier electronics unit 16 of the monitoring electronics 12 unit autonomously and separately from each other during operation. The test electronics unit 20 is configured to execute a function test for testing the amplifier electronics unit 16. The test electronics unit 20 is configured to execute a function test for testing the optical sensor 14.

The amplifier electronics unit 16 comprises an operational amplifier 36. The operational amplifier 36 has an inverting input 42. The operational amplifier 36 has a non-inverting 44 input. The inverting input 42 and the non-inverting input 44 are connected to the optical sensor 14. The optical sensor 14 generates an electric current at the inverting input 42 during a regular operation. The optical sensor 14 generates an electric current at the inverting 42 input during the functional test of the optical sensor 14. The operational amplifier 36 is configured to convert the electric current of the optical sensor 14 into an electric voltage. The operational amplifier 36 has an electrical output 30. The operational amplifier 36 generates a voltage to ground at the output 30. The amplifier electronics unit 16 comprises one resistor 38. The resistor 38 is configured to amplify the voltage of the operational amplifier 36. The amplifier electronics unit 16 comprises one capacitor 40 which is configured to suppress/eliminate noise. A VCC supply 78 of the operational amplifier 36 is connected to the test electronics unit 20.

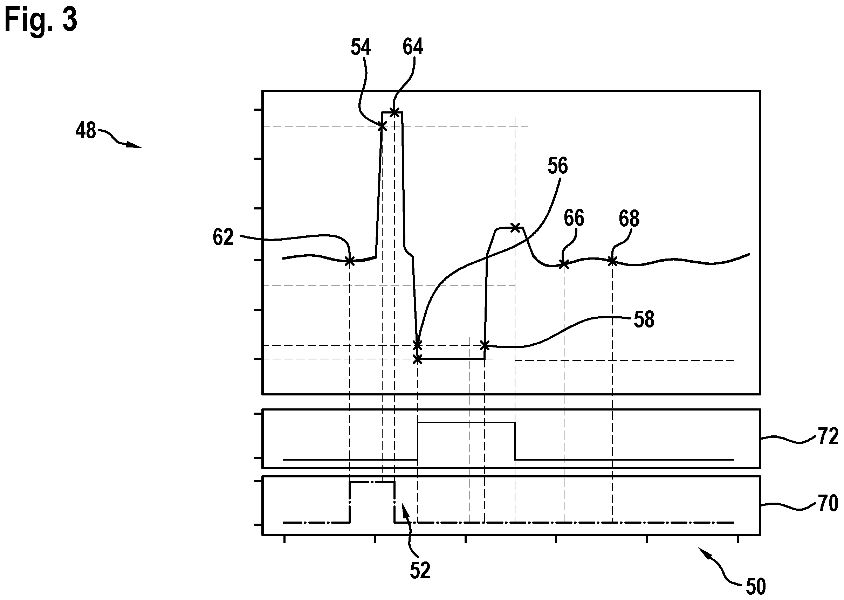

In a regular operation and in the function test of the optical sensor 14, the amplifier electronics unit 16 is configured as a transimpedance amplifier 18. The transimpedance amplifier 18 is configured to convert the electric current of the optical sensor 14 into an electric voltage. The transimpedance amplifier 18 is configured to amplify the electric voltage. During the functional test of the amplifier electronics unit 16, the amplifier electronics unit 16 is configured as a voltage amplifier. The voltage amplifier is configured to amplify an voltage impulse 70, applied on the voltage amplifier (see fig. 3).

The test electronics unit 20 comprises one voltage source 22. The voltage source 22 is embodied as a power plug. The voltage source 22 could also be embodied as a battery. The voltage source 22 is configured as a logical TTL-signal (transistor-transistor-logic). The voltage source 22 is configured to subject the amplifier electronics unit 16 regularly to a voltage impulse 70 for a functionality test. In this embodiment a test interval is every hour. However, the test interval could also be shorter or longer. For example the test interval could be every second. Alternatively or additionally, the monitoring device 34 could also be initiated on demand. The test electronics unit 20 is configured to deactivate the optical sensor 14 in the functionality test of the amplifier electronics unit 16. The test electronics unit 20 is configured to set the optical sensor 14 out of a measuring-sensitive range by the voltage impulse 70. The test electronics unit 20 comprises one light source 24. The light source 24 is embodied as an UV-LED. The light source 24 is configured to subject the optical sensor 14 to a light impulse 72 for a functionality test. The test electronics unit 20 is configured to set the optical sensor 14 back in the measuring-sensitive range by the light impulse 72. The test electronics unit 20 comprises a further capacitor 74. The further capacitor 74 is arranged between the voltage source 22 of the test electronics unit 20 and the inverting input 42 of the operational amplifier 36. The test electronics unit 20 comprises a further resistor 76. The further resistor 76 is connected to the VCC supply 78 of the operational amplifier 36. The further capacitor 74 and the further resistor 76 are arranged to limit a test energy and/or to define a pulse shape.

The figure 3 shows a schematic voltage diagram. The voltage diagram shows the output signal at the amplifier electronics unit 16 (see fig. 2). The voltage diagram contains an ordinate 48. On the ordinate 48 the voltage is plotted. The voltage diagram contains an abscissa 50. On the abscissa 50 the time is plotted. Below the voltage diagram, a switch-on time of the UV-LED for the functional test of the optical sensor 14 is shown. Below the voltage diagram is a switch-on time of the voltage impulse 70 for the functional test of the electronic amplifier unit 16.

The test electronics unit 20 is configured to subject the optical sensor 14 to the light impulse 72 temporally after the voltage impulse 70. The test electronics unit 20 is configured to subject the optical sensor 14 to the light impulse 72 with a temporal delay 52 relative to the voltage impulse 70. The delay 52 is configured as 10 ms. The delay 52 could be configured as a delay 52 of more or less than 10 ms. The voltage impulse 70 set the optical sensor 14 back, out of a measuring-sensitive range. The light impulse 72 is configured to put the optical sensor 14 back into the measuring-sensitive range.

The output voltage before and/or after the function test and/or in a standard measurement mode is about 2 V. The output voltage in the standard measurement mode is less than 4.65 V. However, the output voltage could also be larger or smaller. The output voltage depends on the gain of the amplifier electronics unit 16. The voltage diagram shows the output voltage during the voltage impulse 70 for testing the amplifier electronics unit 16. The voltage diagram shows the output voltage during the light impulse 72 for testing the optical sensor 14. The function test starts 62 with the voltage impulse 70. The functional test comprises a maximum 64 output voltage. The functional test comprises an end 66.

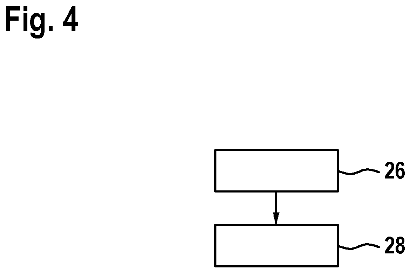

The figure 4 shows a schematic flowchart of a self-test method for testing the monitoring electronics unit 12.

In a first test step 26 a voltage impulse 70 is applied. After applying the voltage impulse 70, an output voltage is generated. A voltage impulse 70 response of the amplifier electronics unit 16 is registered at an output 30 of the amplifier electronics unit 16 in terms of measuring technology. The output voltage, generated by the voltage impulse 70, is different from the output voltages that are to be expected in a regular operation of the monitoring device 34.

In the first test step 26 the voltage impulse 70 is applied for the function test of the electronics amplifier unit 16. By applying the voltage impulse 70, the function test of the amplifier electronics unit 16 is started 62. After a reaction time of the electronic amplifier unit 16 has elapsed, a voltage rise is measured at the output 30 of the electronic amplifier unit 16. As soon as an upper limit value 54 is reached for the output voltage, a part of the function test of the electronic amplifier unit 16 is successfully completed. The maximum 64 output voltage is reached before the electrical voltage impulse 70 is deactivated. After deactivating the voltage impulse 70, the output voltage drops to a value of 0 V. By falling below a lower limit value 56 of 0.5 V a further part of the function test of the electronic amplifier unit 16 is successfully completed (see fig. 3). If one of the limit values 54, 56 is not reached during the function test of the electronic amplifier unit 16, the function test is stopped and an error is reported.

In a second test step 28 the light impulse 72 is applied. The light impulse 72 is applied after the delay 52 has elapsed. After applying the light impulse 72, an output voltage is generated. An increase in the output voltage at the voltage output 30 is measured after a reaction time of the amplifier electronics unit 16. The light impulse 72 response of the amplifier electronics unit 16 is registered at the output 30 of the amplifier electronics unit 16 in terms of measuring technology. As soon as a further lower limit value 58 is exceeded for the output voltage, a further part of the function test of the electronic amplifier unit 16 is successfully completed. The further lower limit value 58 for the output voltage in the functional test of the electronic amplifier unit 16 is 0.5 V. The output voltage, generated by the light impulse 72, is different from the output voltages that are to be expected in a regular operation of the monitoring device 34. After the light impulse 72 is deactivated, the output voltage at the output 30 of the amplifier electronics unit 30 drops to an operating output voltage 68. After reaching the output voltage 68 the functional test of the optical sensor 14 is ended 66. As soon as a difference in the output voltage at the output 30 between an activated light impulse 72 and inactivated light impulse is more than 100 mV the function test of the optical sensor 14 is successfully completed. In case of an inactivated light impulse, the output voltage is determined by the light intensity of the flame 32.

Depending on the design of the test electronics unit 20, the person skilled in the art will set reasonable limit values 54, 56, 58, which will give an unambiguous test result. The first test step 26 for the functionality test of the amplifier electronics unit 16 and the second test step 28 for the functionality test of the optical sensor are carried out in a time interval of less than 1 s, preferably in less than 0.1 s.

The self-test method for testing the monitoring electronics unit 12 is repeated at regular intervals. The self-test method for testing the monitoring electronics unit 12 could also be repeated irregularly. For example, a shorter interval could be applied, if the self-test was not successful in the last self-test method.

## Claims

1. Monitoring device (34), in particular flame monitoring device, with at least one monitoring electronics unit (12) comprising at least one optical sensor (14), in particular a UV-sensor, for monitoring a flame, and comprising an amplifier electronics unit (16), in particular with at least one transimpedance amplifier (18), at least for an amplification of a sensor signal output by the optical sensor (14), wherein the monitoring electronics unit (12) comprises a test electronics unit (20) configured for autonomously testing at least the optical sensor (14) and the amplifier electronics unit (16) of the monitoring electronics (12) unit separately from each other during operation.

2. Monitoring device (34) according to claim 1, wherein the monitoring electronics unit (12) is realized free of movable mechanical components, like for example a covering screen.

3. Monitoring device (34) according to claim 1 or 2, wherein the test electronics unit (20) comprises at least one voltage source (22), which is configured to subject the amplifier electronics unit (16) regularly, in particular at least every hour, to a voltage impulse (70) for a functionality test.

4. Monitoring device (34) according to claim 3, wherein the test electronics unit (20) is configured to deactivate, in the functionality test of the amplifier electronics unit (16), the optical sensor (14), in particular to set the optical sensor (14) back, out of a measuring-sensitive range, by the voltage impulse (70).

5. Monitoring device (34) according to one of the preceding claims, wherein the test electronics unit (20) comprises at least one light source (24), in particular a UV-LED, which is configured to subject the optical sensor (14) to a light impulse (72) for a functionality test.

6. Monitoring device (34) according to claim 3 to 5, wherein the test electronics unit (20) is configured to subject the optical sensor (14) to the light impulse (72) temporally after the voltage impulse (70).

7. Monitoring device (34) according to claim 6, wherein the test electronics unit (20) is configured to subject the optical sensor (14) to the light impulse (72) with a temporal delay (52) relative to the voltage impulse (70).

8. Monitoring device (34) according to one of claims 5 to 7, wherein the light impulse (72) is configured to put the optical sensor (14) back into the measuring-sensitive range.

9. Burning appliance (10) with at least one monitoring device (34) according to one of claims 1 to 8.

10. Self-testing method of a monitoring device according to one of claims 1 to 8, wherein in a first test step (26) a voltage impulse (70) is applied and an output voltage generated by the voltage impulse (70), in particular a voltage impulse (70) response of an amplifier electronics unit (16), is registered at an output (30) of the amplifier electronics unit (16) in terms of measuring technology.

11. Self-testing method according to claim 10, wherein in a second test step (28) a light impulse (72) is applied and an output voltage generated by the light impulse (72), in particular a light impulse (72) response of the amplifier electronics unit (16), is registered at the output (30) of the amplifier electronics unit (16) in terms of measuring technology.

12. Self-testing method according to claim 10 or 11, wherein in the first test step (26) an output voltage is generated by the voltage impulse (70), which is different from the output voltages that are to be expected in a regular operation of the monitoring device.

13. Self-testing method according to claim 10 or 12, wherein in the second test step (28) an output voltage is generated by the light impulse (72), which is different from the output voltages that are to be expected in a regular operation of the monitoring device.

14. Self-testing method according to one of claims 10 to 13, wherein the first test step (26) for the functionality test of the amplifier electronics unit (16) and the second test step (28) for the functionality test of the optical sensor are carried out in a time interval of less than 1 s, preferably in less than 0.1 s.

## Patentansprüche

1. Überwachungsvorrichtung (34), insbesondere Flammenüberwachungsvorrichtung, mit wenigstens einer Überwachungselektronikeinheit (12), die wenigstens einen optischen Sensor (14), insbesondere einen UV-Sensor, zum Überwachen einer Flamme umfasst und eine Verstärkerelektronikeinheit (16), insbesondere mit wenigstens einem Transimpedanzverstärker (18), wenigstens für eine Verstärkung eines Sensorsignals umfasst, das durch den optischen Sensor (14) ausgegeben wird, wobei die Überwachungselektronikeinheit (12) eine Testelektronikeinheit (20) umfasst, die dazu konfiguriert ist, wenigstens den optischen Sensor (14) und die Verstärkerelektronikeinheit (16) der Überwachungselektronikeinheit (12) während des Betriebs getrennt voneinander autonom zu testen.

2. Überwachungsvorrichtung (34) nach Anspruch 1, wobei die Überwachungselektronikeinheit (12) ohne bewegliche mechanische Komponenten, wie zum Beispiel eine Abdeckungsblende, realisiert ist.

3. Überwachungsvorrichtung (34) nach Anspruch 1 oder 2, wobei die Testelektronikeinheit (20) wenigstens eine Spannungsquelle (22) umfasst, die dazu konfiguriert ist, die Verstärkerelektronikeinheit (16) regelmäßig, insbesondere wenigstens jede Stunde, einem Spannungsimpuls (70) für einen Funktionstest zu unterziehen.

4. Überwachungsvorrichtung (34) nach Anspruch 3, wobei die Testelektronikeinheit (20) dazu konfiguriert ist, bei dem Funktionstest der Verstärkerelektronikeinheit (16) den optischen Sensor (14) zu deaktivieren, insbesondere den optischen Sensor (14) durch den Spannungsimpuls (70) aus einem messungsempfindlichen Bereich zurückzusetzen.

5. Überwachungsvorrichtung (34) nach einem der vorhergehenden Ansprüche, wobei die Testelektronikeinheit (20) wenigstens eine Lichtquelle (24), insbesondere eine UV-LED, umfasst, die dazu konfiguriert ist, den optischen Sensor (14) einem Lichtimpuls (72) für einen Funktionstest auszusetzen.

6. Überwachungsvorrichtung (34) nach Anspruch 3 bis 5, wobei die Testelektronikeinheit (20) dazu konfiguriert ist, den optischen Sensor (14) zeitlich nach dem Spannungsimpuls (70) dem Lichtimpuls (72) auszusetzen.

7. Überwachungsvorrichtung (34) nach Anspruch 6, wobei die Testelektronikeinheit (20) dazu konfiguriert ist, den optischen Sensor (14) mit einer zeitlichen Verzögerung (52) relativ zu dem Spannungsimpuls (70) dem Lichtimpuls (72) auszusetzen.

8. Überwachungsvorrichtung (34) nach einem der Ansprüche 5 bis 7, wobei der Lichtimpuls (72) dazu konfiguriert ist, den optischen Sensor (14) wieder in den messungsempfindlichen Bereich zurückzusetzen.

9. Verbrennungsgerät (10) mit wenigstens einer Überwachungsvorrichtung (34) nach einem der Ansprüche 1 bis 8.

10. Selbsttestverfahren einer Überwachungsvorrichtung nach einem der Ansprüche 1 bis 8, wobei in einem ersten Testschritt (26) ein Spannungsimpuls (70) angelegt wird und eine durch den Spannungsimpuls (70) erzeugte Ausgabespannung, insbesondere ein Antwort hinsichtlich des Spannungsimpulses (70) einer Verstärkerelektronikeinheit (16), an einem Ausgang (30) der Verstärkerelektronikeinheit (16) messtechnisch registriert wird.

11. Selbsttestverfahren nach Anspruch 10, wobei in einem zweiten Testschritt (28) ein Lichtimpuls (72) angelegt wird und eine durch den Lichtimpuls (72) erzeugte Ausgabespannung, insbesondere eine Antwort hinsichtlich eines Lichtimpulses (72) der Verstärkerelektronikeinheit (16), an dem Ausgang (30) der Verstärkerelektronikeinheit (16) messtechnisch registriert wird.

12. Selbsttestverfahren nach Anspruch 10 oder 11, wobei in dem ersten Testschritt (26) eine Ausgabespannung durch den Spannungsimpuls (70) erzeugt wird, welche sich von den Ausgabespannungen unterscheidet, die in einem regulären Betrieb der Überwachungsvorrichtung zu erwarten sind.

13. Selbsttestverfahren nach Anspruch 10 oder 12, wobei in dem zweiten Testschritt (28) eine Ausgabespannung durch den Lichtimpuls (72) erzeugt wird, welche sich von den Ausgabespannungen unterscheidet, die in einem regulären Betrieb der Überwachungsvorrichtung zu erwarten sind.

14. Selbsttestverfahren nach einem der Ansprüche 10 bis 13, wobei der erste Testschritt (26) für den Funktionstest der Verstärkerelektronikeinheit (16) und der zweite Testschritt (28) für den Funktionstest des optischen Sensors in einem Zeitraum von weniger als 1 s, vorzugsweise in weniger als 0,1 s, durchgeführt werden.

## Revendications

1. Dispositif de surveillance (34), notamment dispositif de surveillance de flamme, avec au moins une électronique de surveillance (12) comprenant au moins un capteur optique (14), notamment un capteur UV, pour surveiller une flamme, et comprenant une unité électronique d'amplification (16), notamment avec au moins un amplificateur d'impédance (18), au moins pour amplifier un signal de capteur émis par le capteur optique (14), l'unité électronique de surveillance (12) comprenant une unité électronique de test (20) configurée pour tester de manière autonome au moins le capteur optique (14) et l'unité électronique d'amplification (16) de l'unité électronique de surveillance (12) séparément l'une de l'autre pendant le fonctionnement.

2. Dispositif de surveillance (34) selon la revendication 1, dans lequel l'unité électronique de surveillance (12) est réalisée sans composants mécaniques mobiles, comme par exemple un écran de recouvrement.

3. Dispositif de surveillance (34) selon la revendication 1 ou la revendication 2, dans lequel l'unité électronique de test (20) comprend au moins une source de tension (22) configurée pour soumettre l'unité électronique d'amplification (16) régulièrement, notamment au moins toutes les heures, à une impulsion de tension (70) pour un test de fonctionnalité.

4. Dispositif de surveillance (34) selon la revendication 3, dans lequel l'unité électronique de test (20) est configurée pour désactiver, lors du test de fonctionnalité de l'unité électronique amplificatrice (16), le capteur optique (14), notamment pour faire revenir le capteur optique (14), au moyen de l'impulsion de tension (70), hors d'une plage sensible à la mesure.

5. Dispositif de surveillance (34) selon l'une des revendications précédentes, dans lequel l'unité électronique de test (20) comprend au moins une source de lumière (24), notamment une LED UV, configurée pour soumettre le capteur optique (14) à une impulsion lumineuse (72) pour un test de fonctionnalité.

6. Dispositif de surveillance (34) selon les revendications 3 à 5, dans lequel l'unité électronique de test (20) est configurée pour soumettre le capteur optique (14) à l'impulsion lumineuse (72) postérieurement à l'impulsion de tension (70).

7. Dispositif de surveillance (34) selon la revendication 6, dans lequel l'unité électronique de test (20) est configurée pour soumettre le capteur optique (14) à l'impulsion lumineuse (72) avec un retard temporel (52) par rapport à l'impulsion de tension (70).

8. Dispositif de surveillance (34) selon l'une des revendications 5 à 7, dans lequel l'impulsion lumineuse (72) est configurée pour remettre le capteur optique (14) dans la plage sensible à la mesure.

9. Appareil de combustion (10) comportant au moins un dispositif de surveillance (34) selon l'une des revendications 1 à 8.

10. Procédé d'autotest d'un dispositif de surveillance selon l'une des revendications 1 à 8, dans lequel, dans une première étape de test (26), une impulsion de tension (70) est appliquée et une tension de sortie générée par l'impulsion de tension (70), en particulier une réponse d'impulsion de tension (70) d'une unité électronique d'amplification (16), est relevée par mesure à la sortie (30) de l'unité électronique d'amplification (16).

11. Procédé d'autotest selon la revendication 10, dans lequel, dans une deuxième étape de test (28), une impulsion lumineuse (72) est appliquée et une tension de sortie générée par l'impulsion lumineuse (72), en particulier une réponse d'impulsion lumineuse (72) de l'unité électronique d'amplification (16), est relevée par mesure à la sortie (30) de l'unité électronique d'amplification (16).

12. Procédé d'autotest selon la revendication 10 ou la revendication 11, dans lequel, dans la première étape de test (26), une tension de sortie est générée par l'impulsion de tension (70), qui est différente des tensions de sortie attendues lors d'un fonctionnement normal du dispositif de surveillance.

13. Procédé d'autotest selon la revendication 10 ou la revendication 12, dans lequel, dans la deuxième étape de test (28), une tension de sortie est générée par l'impulsion lumineuse (72), qui est différente des tensions de sortie attendues lors d'un fonctionnement normal du dispositif de surveillance.

14. Procédé d'autotest selon l'une des revendications 10 à 13, dans lequel la première étape de test (26) pour le test de fonctionnalité de l'unité électronique d'amplification (16) et la deuxième étape de test (28) pour le test de fonctionnalité du capteur optique sont exécutées dans un intervalle de temps inférieur à 1 s, de préférence inférieur à 0,1 s.
